# EUROPEAN PATENT APPLICATION

(11) **EP 2 708 543 A1**
(43) Date of publication of application: **19.03.2014**
(21) Application number: 12306119.4
(22) Date of filing: 17.09.2012
(51) Int. Cl.: C07F 3/00, C23C 16/00

(54) **Salen-type strontium precursors for vapor phase deposition of thin films**

(71) Applicant: L'AIR LIQUIDE, SOCIETE ANONYME POUR L'ETUDE ET L'EXPLOITATION DES PROCEDES GEORGES CLAUDE, 75007 Paris (FR)
(72) Inventor: Lachaud, Christophe, 91240 SAINT-MICHEL SUR ORGE (FR); Lahootun, Vanina, 91270 VIGNEUX SUR SEINE (FR); Zauner, Andreas, 78960 VOISINS LE BRETONNEUX (FR)
(74) Representative: Grout de Beaufort, François-Xavier

(57) **Abstract**

Compound of formula (I): [(R1R2R3R4R5R6)Salen)]M(A)x

- M is strontium;
- R1, R2, R3, R4, R5, R6 are an organic ligands independently selected in the group consisting of H, C1-C5 linear or branched alkyl;
- A is selected in the group consisting of alcohol, alkylamine, ether;
- 0 ≤ x ≤ 3;

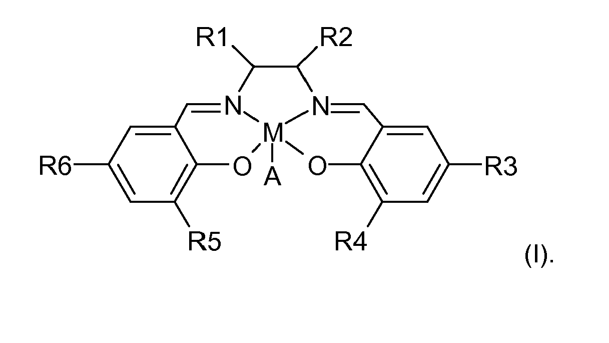

## Description

The invention concerns new salen-type strontium-organic compounds and their use for thin films deposition.

DRAM makers are challenged to keep adequate storage capacitance per cell even as the cell size is shrinking. This has to be achieved by moving to higher aspect ratio 3-D structures, and to ultra-high-k (UHK) materials such as perovskites (ABO₃) materials like strontium titanate (SrTiO₃) or combination such as (Sr,Ba)TiO₃. Strontium can also be used for the deposition of RuSrOₓ for electrode applications.

Various strontium complexes have been studied in the past for the deposition of thin layer films by (MO)CVD (Metal-Organic Chemical Vapor Deposition), ALD (Atomic Layer Deposition) or other vapor phase deposition methods. These complexes include:
- Sr(Me₅Cp)₂, has been used for the deposition of strontium thin films. These precursors are not volatile and sometimes thermally unstable. The temperature of vaporization of Sr(Me₅Cp)₂ is superior to 300°C. The vaporization of the same precursor leads to 20% of residue due to decomposition.
- Amidinate and Guanidinate were studied by ATMI (WO2008/069821 by Tom CAMERON et al). Sr₂(iPr-iPr-iPr-GUA)₄ is an example of this type of precursors. The main disadvantages of this family of precursor are their thermal instability and their lack of volatility. Amidinate and Guanidinate precursors are solid at room temperature with generally a high melting point. Moreover, they tend to form dimeric species.
- β-diketonate ligands generally form solid and non-volatile complexes with Sr. Sr(thd)₂ is a well-known member of the β-diketonate family. The melting point of this precursor is about 210°C and the boiling point is higher than 350°C under atmospheric pressure. Deposition of SrO₂ using Sr(thd)₂ with O₃ results in the formation of SrO₂ along with Sr₂CO₃. No deposition was observed with Sr(thd)₂ and water. This precursor is not convenient for deposition due to difficulties of vaporization.
- Sr(pivalate)₂ were studied by E. ILJINA et al (Materials science & engineering. B, Solid-state materials for advanced technology 1993, 18, 234-236). This precursor is solid and can be sublimed from 370°C. The vapour pressure at this temperature is only 1,33 Pa. The sublimation leads to nearly 60% of residues. This precursor can not be used for the deposition of thin films.

The present invention introduces a new class of low melting point thermally stable strontium metal-organic compounds and their use to deposit strontium containing thin films by either ALD or MOCVD processes.

The invention concerns compounds of formula (I): [(R1R2R3R4R5R6)Salen)]M(A)x
- M is strontium;
- R1, R2, R3, R4, R5, R6 are an organic ligands independently selected in the group consisting of H, C1-C5 linear or branched alkyl;
- A is selected in the group consisting of alcohol, alkylamine, ether;
- 0 ≤ x ≤3; 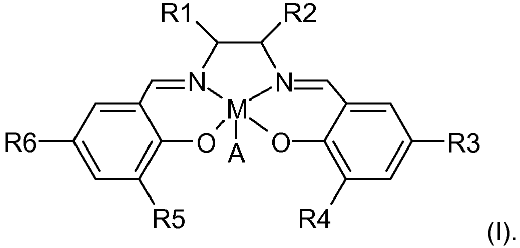
- According to other embodiments, R1, R2, R3, R4, R5, R6 are organic ligands independently selected in the group consisting of H, C1-C5 linear or branched, alkyl, aryl, alkenyl, alkylsilyl, alkylamides, alkylsilylamides, alkoxide, fluoroalkyl.

The inventors have found that this novel family of metal-organic compounds presents particularly attractive thermal properties. According to the inventors, the proposed new precursors present the advantages of:
1) Having a melting point lower than 150°C.
2) Being thermally stable enough to enable proper distribution (gas phase or direct liquid injection) without particles generation.
3) Being thermally stable enough to allow wide self-limited ALD window.
4) Allowing the deposition of a variety of strontium containing films, including ternary or quaternary materials, by using one or a combination of co-reactants (selected among the group consisting of O₂, Plasma O₂, H₂O, O₃, TBTDET, TBTDMT, TBTDETCp, TiCl₄, CpTi(OMe)₃, Ta(OEt)₄, Ta(OMe)₅, Ti(OiPr)₄, etc).

According to another embodiment, the invention concerns a method of forming a strontium -containing layer on a substrate surface, the method comprising at least the steps of:
a) providing a vapor comprising at least one precursor compound of the formula (I) as defined above;
b) reacting the vapor comprising the at least one compound of formula (I) with the substrate, according to a method selected from (MO)CVD (Metal-Organic Chemical Vapor Deposition), ALD (Atomic Layer Deposition), PEALD (Plasma Enhanced Atomic Layer Deposition), PECVD (Plasma Enhanced Chemical Vapor Deposition) and derivative vapor phase deposition methods, to form a layer of a at least strontium -containing complex on at least one surface of said substrate.

According to another embodiment, the invention concerns a method as defined above further comprising the step:
c) reaction of the complex obtained in step b) with at least one reactant selected from another metal source, reducing reactants and/or nitriding reactants and/or oxidizing reactants.

According to another embodiment, the invention concerns a method as defined above, wherein the at least one reactant is selected in the group consisting of, oxygen (O₂), oxygen radicals (for instance O· or OH·), for instance generated by a remote plasma, ozone (O₃), moisture (H₂O) and H₂O₂.

According to another embodiment, the invention concerns a method as defined above, wherein the at least one reactant is selected in the group consisting of SiH₄, Si₂H₆, Si₃H₈, SAM 24 (SiH₂(NEt₂)₂ Bis(diethylamino)silane), TriDMAS (SiH(NMe₂)₃), BDMAS (SiH₂(NMe₂)₂), BDEAS (SiH₂(NEt₂)₂), TDEAS (SiH(NEt₂)₃), TDMAS (SiH(NMe₂)₃), 3MS (trimethylsilane), 4MS (tetramethylsilane), TEMAS (SiH(NEtMe)₃), (SiH₃)₃N, (SiH₃)₂O, trisilylamine, disiloxane, trisilylamine, a alkoxysilane SiHₓ(OR¹)₄₋ₓ (where x is comprised between 0 and 3), a silanol Si(OH)ₓ(OR¹)₄₋ₓ (preferably Si(OH)(OR¹)₃ ; more preferably Si(OH)(OtBu)₃ an aminosilane SiHₓ(NR¹R²)₄₋ₓ (where x is comprised between 0 and 3); R¹ and R² are independently from H or a C1-C6 carbon chain, either linear, branched or cyclic; preferably TriDMAS SiH(NMe₂)₃, BTBAS SiH₂(NHtBu)₂; BDEAS SiH₂(NEt₂)₂ and mixtures thereof.

According to another embodiment, the invention concerns a method as defined above, wherein the reactants can be introduced simultaneously (chemical vapor deposition), sequentially (atomic layer deposition) or different combinations such as introducing strontium source and the other precursor source together in one pulse and oxygen in a separate pulse (modified atomic layer deposition); or introducing oxygen continuously and to introduce metal source by pulse (pulsed-chemical vapor deposition).

According to another embodiment, the invention concerns a method as defined above, wherein said another metal source is selected from any other element in the group II, III-A, III-B, transition metal, lanthanoids, or rare-earth metals.

According to another embodiment, the invention concerns a method as defined above, wherein the temperature of the substrate is comprised between 300°C and 450°C.

According to another embodiment, the invention concerns a method as defined above, wherein the substrate is selected in the group consisting of Si, SiOₓ, SiNₓ, SiOₓN_{y}, Cu, GeOₓ.

According to another embodiment, the invention concerns a substrate coated with one or more film monolayers of one or more metals, obtained by a method selected from (MO)CVD (Metal-Organic Chemical Vapor Deposition), ALD (Atomic Layer Deposition), PEALD (Plasma Enhanced Atomic Layer Deposition), PECVD (Plasma Enhanced Chemical Vapor Deposition) and derivative vapor phase deposition methods, wherein at least one precursor is a metal source precursor as defined above.

According to another embodiment, the invention concerns a method of manufacturing a semiconductor device product comprising contacting a semiconductor device substrate with a strontium source precursor as defined above, to deposit strontium on the substrate.

According to another embodiment, the invention concerns a method of manufacturing a photovoltaic device product comprising contacting a photovoltaic device substrate with a strontium source precursor as defined above, to deposit strontium on the substrate.

The new metal-organic precursors of the invention have a melting point lower than 150°C, or easily to liquefy for easy handling.

These new metal organic precursors exhibit a vapour pressure equal or higher than 1 mbar at 100°C.

### Method of depositing strontium containing thin films:

The deposition of a strontium containing film is performed in several steps:
a. Vaporization of a strontium precursor so as to form a gas phase strontium source.
b. Introducing several precursors in vapor phase in a deposition device, wherein said precursors comprise of vaporized strontium source, and may comprise of another metal source, an oxygen source, a nitrogen source, a carbon source; to form a strontium containing film.
   1. In one embodiment of the invention, the vaporization of the new precursor can be realized by introducing a gas in a canister containing the said new precursor. The canister is preferably heated at a temperature which allows a sufficient vapor pressure for the said new precursor. The carrier gas can be selected, from Ar, He, H₂, N₂ or mixtures of them. The canister can be heated for instance at temperatures in the range of 80°C -170°C. The temperature can be adjusted to control the amount of precursor in the gas phase.
   2. In another embodiment of the invention, the said new precursor source can be mixed to a solvent or a mixture of solvents, to another metal source or to a mixture of them. This mixture is contained in a canister which can be heated at temperature in the range of 80°C-170°C. The temperature can be adjusted to control the amount of precursor in the gas phase.
   3. In another embodiment of the invention, the said new precursor source is fed to a vaporizer where it is vaporized. The said new precursor source can be mixed to another metal source. The said mixture can be mixed to a solvent or a mixture of solvents. The said metal source can be mixed to a stabilizer. The said mixture can be introduced in a vaporizer where it is vaporized. The said solvent can be selected from the group consisting of octane, hexane, pentane, tetramethylsilane, mesithylene, etc.
   4. In another embodiment of the invention, the said new precursor source can be mixed to another precursor and the mixture is fed to a vaporizer where it is vaporized. The said mixture can be mixed to a solvent or a mixture of solvents. The said solvent can be selected from the group consisting of octane, hexane, pentane, tetramethylsilane, mesithylene, etc
   5. In one embodiment of the invention, the pressure in the said canister is in the range from 1 Pa to 13300 Pa or higher.
   6. The said vaporized metal source is introduced into a reaction chamber where it is in contact with a substrate. The substrate can be selected from the group consisting of Si, SiO₂, SiN, SiON, and other metal containing films. The substrate can be heated to an adequate temperature so as to obtain the desired film with a sufficient growth rate and with desired physical state and composition. Typical temperature ranges from 150°C to 600°C. Preferably the temperature is lower or equal to 450°C. The pressure in the reaction chamber is controlled to obtain the desired metal containing film at sufficient growth rate. Typical pressure ranges from 1 Pa level to 13300 Pa or higher.
   7. In one embodiment of the invention, the said new precursor source or the mixture described in 2, 3, 4 is mixed to one or more reactant species prior to the reaction chamber.
   8. In one embodiment of the invention, the said new precursor source or the mixture described in 2, 3, 4 is mixed to one or more reactant species in the reaction chamber.
   9. In another embodiment of the invention, the said new precursor and the reactant species are introduced sequentially in the reaction chamber. The said new precursor and the reactant species can be introduced simultaneously (chemical vapor deposition), sequentially (atomic layer deposition) or different combinations (one example is to introduce metal source and the other metal source together in one pulse and oxygen in a separate pulse (modified atomic layer deposition); another example is to introduce the reactant species (one example could be oxygen) continuously and to introduce metal source by pulse (pulsed-chemical vapor deposition)
   10.In one embodiment of the invention, the reactant species are passed through a plasma system localized remotely from the reaction chamber, and decomposed to radicals.
   11.In one embodiment of the invention where the targeted metal based film contains oxygen, such as for example SrTiO₃ the said reactant species include an oxygen source which is selected from oxygen (O₂), oxygen radicals (for instance O· or OH·), for instance generated by a remote plasma, ozone (O₃), moisture (H₂O) and H₂O₂.
   12.In one embodiment of the invention one or more reactant species containing nitrogen can be use. The said reactant species are selected from nitrogen (N₂), ammonia, and alkyl derivatives.
   13.In one embodiment of the invention, the said metal sources are simultaneously introduced and mixed into the reaction chamber.
   14.In another embodiment of the invention, the said metal sources are simultaneously introduced and mixed to reactant species into the reaction chamber.
   15.In one embodiment of the invention, the said new precursor is used for atomic layer deposition of strontium containing films. The said strontium source, the possible said metal source and the reactant species are introduced sequentially in the reaction chamber (atomic layer deposition). The reactor pressure is selected in the range from 1 Pa to 13300 Pa. Preferably, the reactor pressure is comprised between 133 Pa and 1330 Pa. A purge gas is introduced between the metal source pulse and the reactant species pulse. The purge gas can be selected from the group consisting of N₂, Ar, He. The metal source, purge gas and reactant species pulse duration is comprised between 0.1 and 100 s. Preferably the pulse duration is comprised between 0.5 and 10 s.
   16.In one embodiment of the invention, the second metal source is selected in the group of TBTDET, TBTDMT, (Cp)Ti(OtBu)₃, (Cp)Ti(OiPr)₃, (Cp)Ti(OEt)₃, (Me₅Cp)Ti(OtBu)₃, (Me₅Cp)Ti(OiPr)₃, (Me₅Cp)Ti(OEt)₃, TiCl₄, Ti(OMe)₄, Ta(OEt)₄, Ta(OMe)₅, CpTa(NEt₂)N(tBu), Sr(iPr₃Cp)₂, Ba(iPr₃Cp)₂ etc.
   17.In one embodiment, the reactants can be introduced simultaneously (chemical vapor deposition), sequentially (atomic layer deposition) or different combinations (one example is to introduce strontium source and the other precursor source together in one pulse and oxygen in a separate pulse (modified atomic layer deposition); another example is to introduce oxygen continuously and to introduce metal source by pulse (pulsed-chemical vapor deposition).
   18. In another embodiment of the invention, the deposition of the strontium containing thin film is performed by a combination of the previous elements (point 1 to 17).

### 6. EXAMPLES

### New strontium compounds containing salen ligands:

Examples of new strontium molecules disclosed in the present invention include:
[(R1R2R3R4R5R6)Salen)]Sr(EtOH)₃ where R1=R2=H, R3=R4=R5=R6=Me;
[(R1R2R3R4R5R6)Salen)]Sr(EtOH)₃ where R1=R2=Me, R3=R4=R5=R6=tBu;
[(R1R2R3R4R5R6)Salen)]Sr(EtOH)₃ where R1=R2=Et, R3=R4=R5=R6=tBu;
[(R1R2R3R4R5R6)Salen)]Sr(EtOH)₃ where R1=R2=i-Pr, R3=R4=R5=R6=tBu;
[(R1R2R3R4R5R6)Salen)]Sr(THF)₃ where R1=R2=Me, R3=R4=R5=R6=tBu;
[(R1R2R3R4R5R6)Salen)]Sr(THF)₃ where R1=R2=Me, R3=R4=R5=R6=i-Pr;
[(R1R2R3R4R5R6)Salen)]Sr(DME)₃ where R1=R2=Me, R3=R4=R5=R6=Me;
[(R1R2R3R4R5R6)Salen)]Sr(EtOH)₃ where R1=R2=Me, R3=R4= Me,R5=R6=tBu.

## Claims

1. Compound of formula (I): [(R1R2R3R4R5R6)Salen)]M(A)x
- M is strontium;
- R1, R2, R3, R4, R5, R6 are an organic ligands independently selected in the group consisting of H, C1-C5 linear or branched alkyl;
- A is selected in the group consisting of alcohol, alkylamine, ether;
- 0 ≤ x ≤ 3;

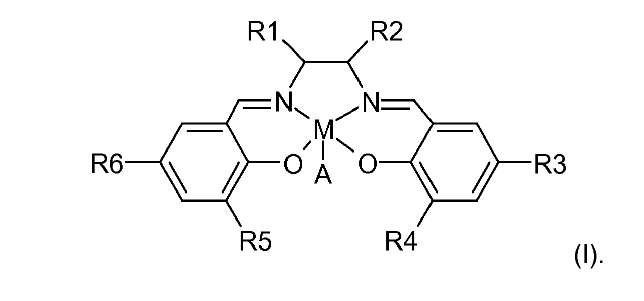

2. Compounds:
[(R1R2R3R4R5R6)Salen)]Sr(EtOH)₃ where R1=R2=H, R3=R4=R5=R6=Me;
[(R1R2R3R4R5R6)Salen)]Sr(EtOH)₃ where R1=R2=Me, R3=R4=R5=R6=tBu;
[(R1R2R3R4R5R6)Salen)]Sr(EtOH)₃ where R1=R2=Et, R3=R4=R5=R6=tBu;
[(R1R2R3R4R5R6)Salen)]Sr(EtOH)₃ where R1=R2=i-Pr, R3=R4=R5=R6=tBu;
[(R1R2R3R4R5R6)Salen)]Sr(THF)₃ where R1=R2=Me, R3=R4=R5=R6=tBu;
[(R1R2R3R4R5R6)Salen)]Sr(THF)₃ where R1=R2=Me, R3=R4=R5=R6=i-Pr;
[(R1R2R3R4R5R6)Salen)]Sr(DME)₃ where R1=R2=Me, R3=R4=R5=R6=Me;
[(R1R2R3R4R5R6)Salen)]Sr(EtOH)₃ where R1=R2=Me, R3=R4= Me,R5=R6=tBu.

3. Method of forming a strontium-containing layer on a substrate surface, the method comprising at least the steps of:
a) providing a vapor comprising at least one precursor compound (I) as defined in claim 1 or 2;
b) reacting the vapor comprising the at least one compound (I) with the substrate, according to a method selected from (MO)CVD (Metal-Organic Chemical Vapor Deposition), ALD (Atomic Layer Deposition), PEALD (Plasma Enhanced Atomic Layer Deposition), PECVD (Plasma Enhanced Chemical Vapor Deposition) and derivative vapor phase deposition methods, to form a layer of a at least strontium-containing complex on at least one surface of said substrate.

4. Method of claim 3 further comprising the step:
c) reaction of the complex formed obtained in step b) with at least one reactant selected from another metal source, reducing reactants and/or nitriding reactants and/or oxidizing reactants.

5. Method of claim 4, wherein the at least one reactant is selected in the group consisting of, oxygen (O₂), oxygen radicals (for instance O· or OH·), for instance generated by a remote plasma, ozone (O₃), moisture (H₂O) and H₂O₂.

6. Method of claim 4, wherein the at least one reactant is selected in the group consisting of SiH₄, Si₂H₆, Si₃H₈, SAM24 (SiH₂(NEt₂)₂ Bis(diethylamino)silane), TriDMAS (SiH(NMe₂)₃), BDMAS (SiH₂(NMe₂)₂), BDEAS (SiH₂(NEt₂)₂), TDEAS (SiH(NEt₂)₃), TDMAS (SiH(NMe₂)₃), 3MS (trimethylsilane), 4MS (tetramethylsilane), TEMAS (SiH(NEtMe)₃), (SiH₃)₃N, (SiH₃)₂O, trisilylamine, disiloxane, trisilylamine, a alkoxysilane SiHₓ(OR¹)₄₋ₓ (where x is comprised between 0 and 3), a silanol Si(OH)ₓ(OR¹)₄₋ₓ (preferably Si(OH)(OR¹)₃ ; more preferably Si(OH)(OtBu)₃ an aminosilane SiHₓ(NR¹R²)₄₋ₓ (where x is comprised between 0 and 3); R¹ and R² are independently from H or a C1-C6 carbon chain, either linear, branched or cyclic; preferably TriDMAS SiH(NMe₂)₃, BTBAS SiH₂(NHtBu)₂; BDEAS SiH₂(NEt₂)₂ and mixtures thereof.

7. Method of one of claims 4 to 6, wherein the reactants can be introduced simultaneously (chemical vapor deposition), sequentially (atomic layer deposition) or different combinations such as introducing strontium source (I) and the other precursor source together in one pulse and oxygen in a separate pulse (modified atomic layer deposition); or introducing oxygen continuously and to introduce metal source by pulse (pulsed-chemical vapor deposition).

8. Method of one of claims 4 to 7, wherein said another metal source is selected in the group of TBTDET, TBTDMT, (Cp)Ti(OtBu)₃, (Cp)Ti(OiPr)₃, (Cp)Ti(OEt)₃, (Me₅Cp)Ti(OtBu)₃, (Me₅Cp)Ti(OiPr)₃, (Me₅Cp)Ti(OEt)₃, TiCl₄, Ti(OMe)₄, Ta(OEt)₄, Ta(OMe)₅, CpTa(NEt₂)N(tBu), Sr(iPr₃Cp)₂, Ba(iPr₃Cp)₂.

9. Method of one of claims 3 to 8, wherein the temperature of the substrate is comprised between 300°C and 450°C.

10. Method of one of claims 3 to 9, wherein the substrate is selected in the group consisting of Si, SiOₓ, SiNₓ, SiOₓN_{y}, Cu, GeOₓ.

11. A substrate coated with one or more film monolayers of one or more metals, obtained by a method selected from (MO)CVD (Metal-Organic Chemical Vapor Deposition), ALD (Atomic Layer Deposition), PEALD (Plasma Enhanced Atomic Layer Deposition), PECVD (Plasma Enhanced Chemical Vapor Deposition) and derivative vapor phase deposition methods, wherein at least one precursor is a metal source precursor as defined in claim 1 or 2.

12. Method of manufacturing a semiconductor device product comprising contacting a semiconductor device substrate with a strontium source precursor as defined in claim 1 or 2, to deposit strontium on the substrate.

13. Method of manufacturing a photovoltaic device product comprising contacting a photovoltaic device substrate with a strontium source precursor as defined in claim 1 or 2, to deposit strontium on the substrate.
